# EUROPEAN PATENT APPLICATION

(11) **EP 1 528 599 A2**
(43) Date of publication of application: **04.05.2005**
(21) Application number: 03029920.0
(22) Date of filing: 29.12.2003
(51) Int. Cl.: H01L 29/78, H01L 21/336

(54) **Method for fabricating a semiconductor transistor device**

(30) Priority: 28.10.2003 KR 2003075431; 28.10.2003 KR 2003075440; 07.11.2003 KR 2003078770
(71) Applicant: Dongbu Electronics Co., Ltd., Seoul 135-523 (KR)
(72) Inventor: Park, Jeong Ho, Icheon-si Gyeonggi-do 467-902 (KR)
(74) Representative: Appelt, Christian W.

(57) **Abstract**

A method for fabricating a transistor of a semiconductor device is disclosed. The method for fabricating a transistor of a semiconductor device according to the present invention comprises the steps of forming an LDD region using an ion implantation after depositing a first insulating layer on a semiconductor substrate; forming a trench in the substrate after patterning the first insulating layer; forming a trench gate by depositing and planarizing a second insulating layer and a conductor on the substrate with the trench; forming a source/drain region by forming a photoresist pattern on the substrate with the trench gate and performing an ion implantation using the photoresist pattern as a mask; and removing the photoresist pattern and the first insulating layer.

Thus, a method for fabricating a transistor of a semiconductor device according to the present invention can lower source/drain resistance and gate resistance without any additional process by forming a trench type gate and can efficiently control a short channel effect.

## Description

### BACKGROUND OF THE INVENTION

### Field of the Invention

The present invention relates to a method for fabricating a transistor of a semiconductor device and, more particularly, to a method for fabricating a transistor which can lower source/gate resistance and gate resistance without any additional process by forming a trench type gate and can efficiently control a short channel effect.

### Background of the Related Art

Nowadays, width of a transistor gets continuously finer due to miniaturization and high integration of semiconductor. As a consequence, a hot carrier effect occurs inside a transistor. The effect degrades electrical characteristics of a drain region, as a horizontal electric field is largely concentrated on the drain region when a channel length is shorter relative to an external voltage applied. Moreover, holes generated move out toward a substrate. On the contrary, electrons are trapped under a gate oxide layer or spacers and affect a threshold voltage.

Though the channel region gets short due to the miniaturization of a device, a voltage of supplied power is invariably constant. The hot carrier effect occurs frequently when high electric field is applied to the channel in the substrate. Especially, the effect becomes more severe as the channel length between the source and drain regions becomes shorter.

In order to overcome the hot carrier effect, most processes of fabricating transistors employ an LDD (Lightly Doped Drain) structure. The structure has a graded junction where ion implant density in the source/drain region is low around edges of a gate electrode and high around center of the gate electrode, thereby reducing abrupt change of the electric field.

However, the transistor with an LDD structure causes a short channel effect since the channel length gets continuously shorter due to the high integration of the semiconductor device. Then, dopants in the LDD region diffuse to the channel and high electric field is applied in the channel edge between drains, which causes the hot carrier effect that degrades performance of the transistor.

Further, in operation of the transistor, impurities in source and drain regions diffuse to laterals and induce a punch-through effect easily. So, lots of ion implant processes are required to prevent the punch-through effect. Also, control of the threshold voltage is difficult when the channel length and the density control are not accurate.

To solve these problems, Korean Published Patent No. 2001-64434 discloses a transistor of trench-type gate electrode structure. The transistor structure has a lower part of a transistor gate electrode buried in a substrate between spacers and a groove type gate oxide layer on the laterals and the lower part of the gate electrode, thereby increasing an effective channel length. Thus, the transistor enhances electrical characteristics of a high integration semiconductor device. However, this art also causes some problems in the miniaturization of the device since the gate is still higher than the silicon substrate due to the only partial burial of the gate.

U.S. Patent No. 6,511,886, Kim et al., and Korean Patent No. 10-0218260 disclose the method of forming a uniform oxide layer on the surface of a trench for a gate by rounding corners of the trench. However, the art requires an additional mask process in forming a source/drain region, so the fabrication process is complicated.

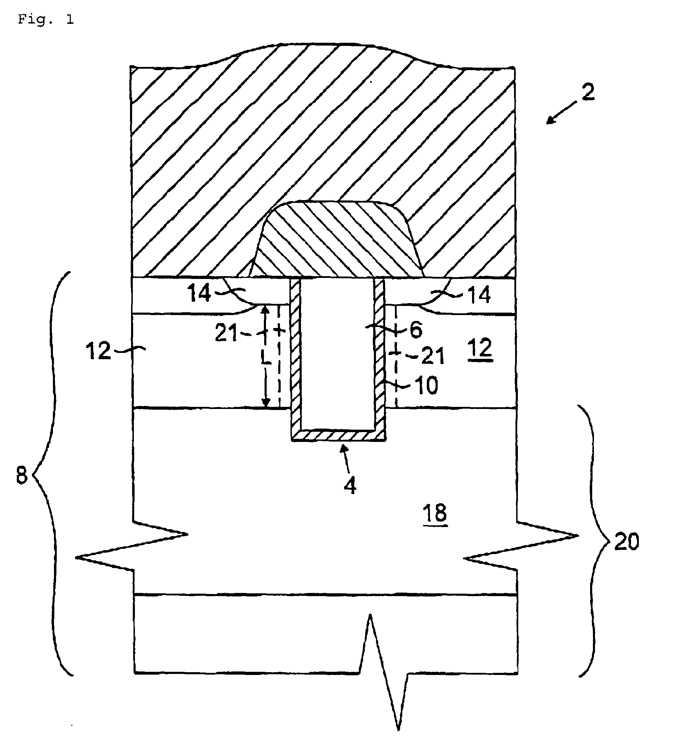

A MOSFET (Metal Oxide Semiconductor Field Effect Transistor) using a trench gate provides a low turn-on resistance. In such a trench MOSFET device, the channel is arranged in a vertical fashion rather than a horizontal fashion which is often used in a plane composition. FIG. 1 illustrates a part of sectional view of a conventional trench gate MOSFET device 2. The MOSFET device includes a trench 4 filled with a conductive material separated from the silicon region 8 by a thin layer of an insulating material 10. A body region 12 is diffused from an epitaxial layer 18 and a source region 14 is sequentially diffused from the body region 12. The conducting material 6 and the insulating material 10 in the trench 4 form a gate and a gate oxide layer of a trench DMOS, respectively. Besides, the depth L measured from the source 14 to the epitaxial layer 18 constitutes a channel length L of the trench DMOS device. The epitaxial layer 18 is a part of drain of the trench DMOS device. When a potential difference is applied between the body 12 and the gate 6, an electric charge is induced in the body region 12 adjacent to the gate oxide layer 10. This results in formation of a channel of the trench DMOS device.

The above structure of the transistor is called the dual diffusion MOSFET, i.e., the 'trench DMOS', due to the two diffusion steps into the body region and the epitaxial layer. Such a trench DMOS transistor is disclosed in U.S. Patent No. 5,907,776, Hshieh et al., U.S. Patent No. 5,072,266, Bulucea et al., U.S. Patent No. 5,541,425, Nishihara, and U.S. Patent No. 5,866,931, Bulucea et al. However, in the above-mentioned arts, the miniaturization of the device has the limitation due to the separation of the source/drain regions and fabrication processes are complicated.

### BRIEF DESCRIPTION OF THE DRAWINGS

The accompanying drawings, which are included to provide a further understanding of the invention and are incorporated in and constitute a part of this application, illustrate embodiments of the invention and together with the description serve to explain the principle of the invention. In the drawings:
Fig. 1 illustrates a part of sectional view of a conventional trench gate MOSFET device.
Figs. 2a through 2g illustrate a cross-sectional view of a method for fabricating a transistor according to an embodiment of the present invention.
Figs. 3a through 3g illustrate a cross-sectional view of a method for fabricating a transistor according to another embodiment of the present invention.
Figs. 4a through 4g illustrate a cross-sectional view of a method for fabricating a transistor according to still another embodiment of the present invention.

### DETAILED DESCRIPTION OF THE PREFERRED EMBODIMENT

The present invention is directed to a method for fabricating a transistor of a semiconductor device that substantially obviates one or more problems due to limitations and disadvantages of the related art.

An object of the present invention is to provide a method for fabricating a transistor device which can lower source/drain resistance and gate resistance without any additional process by forming a trench type gate and can efficiently control a short channel effect.

To achieve the object, the present invention provides a method for fabricating a transistor of a semiconductor device comprising the steps of:
forming an LDD region using an ion implantation after depositing a first insulating layer on a semiconductor substrate;
forming a trench in the substrate after patterning the first insulating layer;
forming a trench gate by depositing and planarizing a second insulating layer and a conductor on the substrate with the trench;
forming a source/drain region by forming a photoresist pattern on the substrate with the trench gate and performing an ion implantation using the photoresist pattern as a mask; and
removing the photoresist pattern and the first insulating layer.

The present invention provides another method for fabricating a transistor of a semiconductor device comprising the steps of:
forming an LDD region using an ion implantation on a substrate;
forming a first insulating layer on the substrate;
forming a trench in the substrate after patterning the first insulating layer;
forming a trench gate by depositing and planarizing a second insulating layer and a conductor on the substrate with the trench;
anisotropically etching the first insulating layer to form spacers; and
forming a source/drain region by performing an ion implantation on the substrate using the spacers and the gate as a mask.

The present invention provides still another method for fabricating a transistor of a semiconductor device comprising the steps of:
forming an LDD region using an ion implantation after depositing a first insulating layer on a semiconductor substrate;
forming a trench in the substrate after patterning the first insulating layer;
forming a trench gate by depositing and planarizing a second insulating layer and a first conductor on the substrate with the trench;
depositing a second conductor on the substrate with the trench gate and patterning the second conductor and the first insulating layer; and
forming a source/drain region by performing an ion implantation using the second conductor pattern as a mask.

References will now be made in detail to the preferred embodiments of the present invention, examples of which are illustrated in the accompanying drawings.

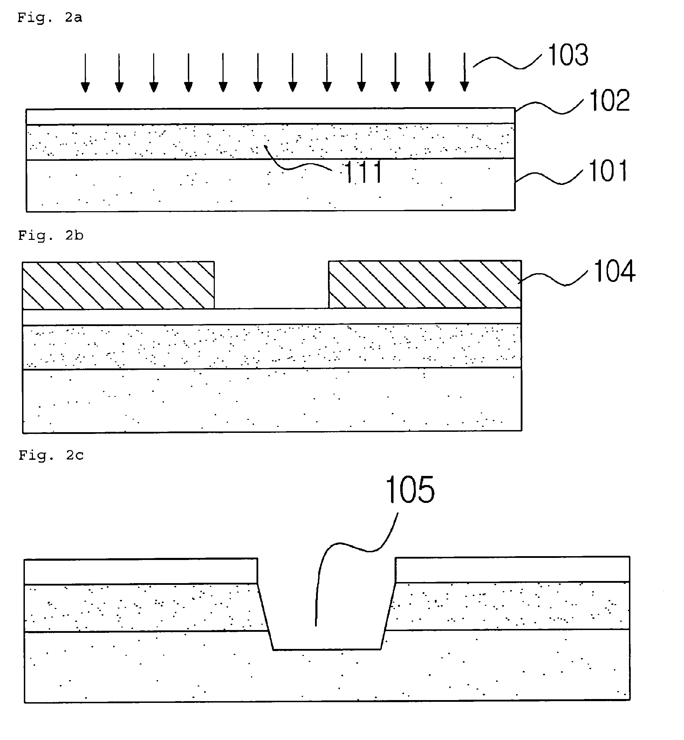

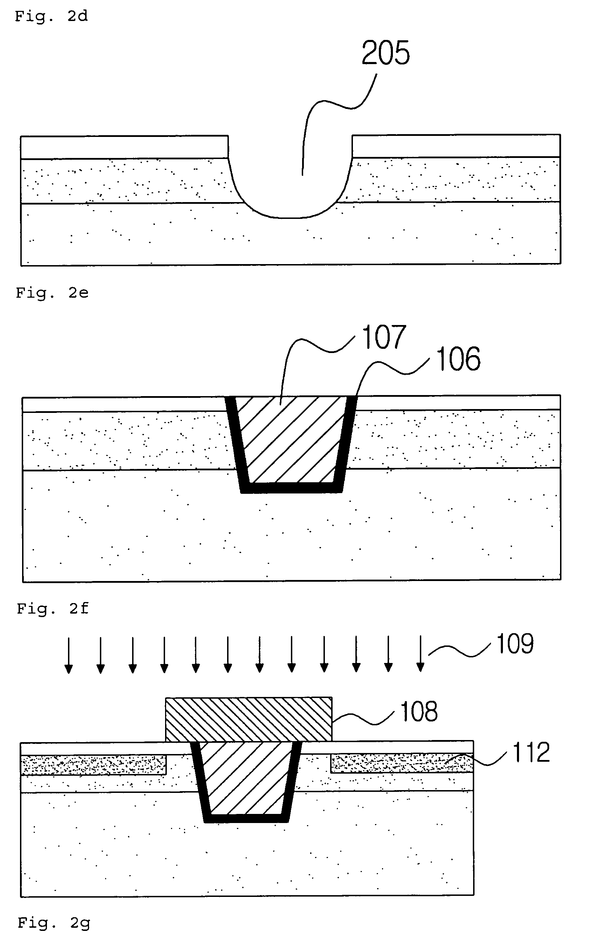

FIGS. 2a through 2g illustrate an embodiment of the present invention.

First, referring to FIG. 2a, a first insulating layer 102 is deposited on a silicon substrate 101 and an LDD region 111 is formed using an ion implantation 103. The first insulating layer works as a buffer layer for the ion implantation and is preferably formed of one selected from the group consisting of nitrides, tantalum oxides, titanium oxides, and hafnium oxides. The ion implantation energy to form the LDD region preferably has a value between 30 keV and 80 keV. The thickness of the first insulating layer preferably has a value between 500 Å and 1500 Å.

Referring to FIG. 2b, a first photoresist 104 is deposited on the first insulating layer and patterned. A first photoresist is formed on the first insulating layer. Then, an area for a gate is patterned in the first photoresist with development and lithography processes.

Referring to FIG. 2c, a trench 105 is formed by etching the substrate. A trench for a gate is formed by etching the first insulating layer and the substrate using the first photoresist patterned as a mask. Then, the first photoresist is removed. The etching method may be dry etching with an etching angle between 5° to 30°.

As illustrated in FIG. 2d, the etching method may be an etchback using CDE (Chemical Dry Etching) to form lower edges of the trench in a rounded shape 205. Therefore, uniformity of a layer to be deposited later can be increased. The trench length preferably has a value between 100 Å and 1000 Å.

Referring to FIG. 2e, a trench gate is formed by depositing and planarizing a second insulating layer 106 and a conductor 107. An oxide layer for a second insulating layer is formed on the substrate in which the trench is already formed. A conductor for a gate is formed on the second insulating layer. Next, a trench gate is formed by planarizing the conductor and the second insulating layer using CMP (Chemical Mechanical Polishing). The first insulating layer is used as an etch-stop layer. When the first insulating layer is exposed, the CMP process is stopped. The conductor is preferably made of one selected from the group consisting of tungsten alloy, titanium alloy, and tantalum alloy. The second insulating layer may be formed of silicon dioxide using a conventional thermal oxide method or chemical vapor deposition and a multi-layer of oxide material can be also used. In addition, a gate insulating layer such as silicon nitride can be used. The thickness of the second insulating layer preferably has a value between 15 Å and 80 Å.

Referring to FIG. 2f, after a second photoresist 108 is formed and patterned, a source/drain region 112 is formed by an ion implantation 109 using the second photoresist as a mask. A second photoresist is deposited on the substrate in which the trench gate is already formed and patterned. A source/drain region is formed by an ion implantation using the second photoresist as a mask. The ion implantation energy to form the source/drain region preferably has a value between 5 keV and 60 keV. The first insulating layer is used as a buffer layer for the ion implantation to protect the substrate.

Referring to FIG. 2g, the second photoresist and the first insulating layer are removed. The first layer is removed by a wet etching. The wet etching preferably employs phosphoric acid solution.

The LDD region 111 and the source/drain region 112 are formed above the gate. However, the LDD region and the source/drain region are stabilized and diffused by a later thermal process, so that channel length can be controlled.

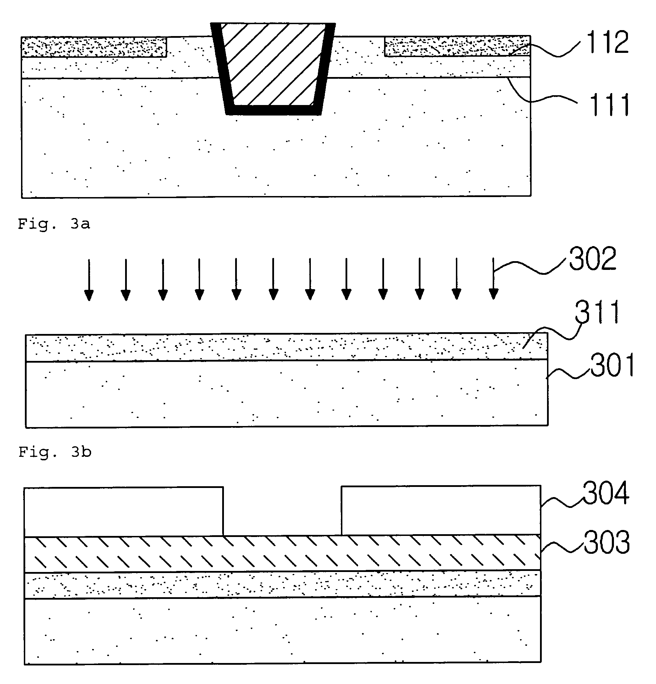

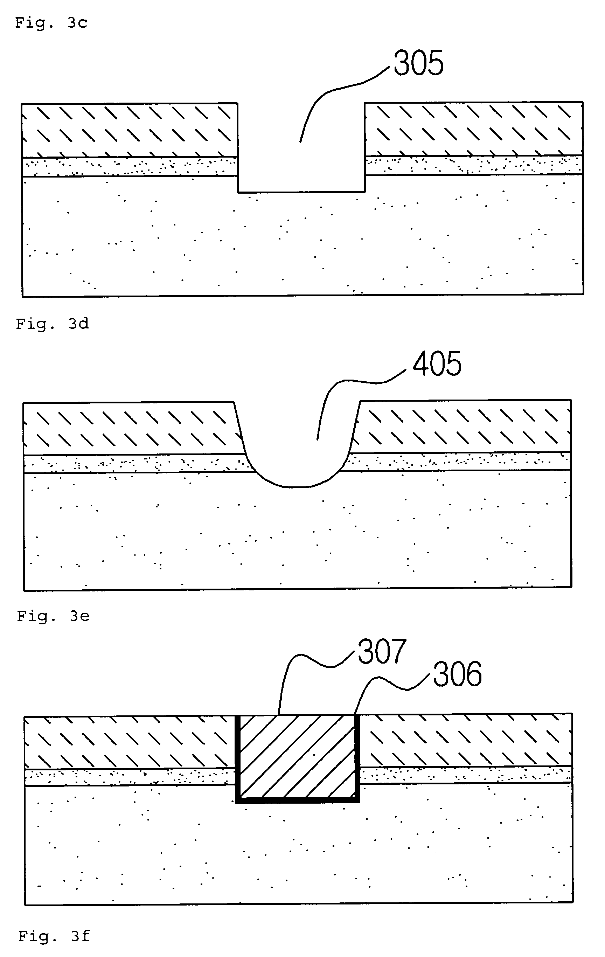

FIGS. 3a through 3g illustrate another embodiment of the present invention.

Referring to FIG. 3a, an LDD region 311 is formed on a silicon substrate 301 using an ion implantation 302. For a conventional transistor with a gate on a silicon substrate, a gate is formed first, and an LDD region is formed by an ion implantation process of impurities of low concentration using the gate as a mask. According to another embodiment of the present invention, an LDD region is formed by the ion implantation process of impurities of low concentration prior to formation of a gate. The ion implantation energy to form the LDD region preferably has a value between 10 keV and 80 keV.

Referring to FIG. 3b, a first insulating layer 303 is formed on the substrate and a photoresist 304 is deposited on the first insulating layer and patterned. A first insulating layer is deposited on the substrate on which the LDD region is already formed. A photoresist is formed on the first insulating layer. Then, an area for a gate is patterned with development and lithography processes. The first insulating layer is preferably a nitride layer or an oxide layer.

Referring to FIG. 3c, a trench 305 is formed by etching the first insulating layer and the substrate. A trench for a gate is formed by etching the first insulating layer and the substrate using the photoresist as a mask and then the photoresist is removed. The etching method may be a dry etching.

As illustrated in FIG. 3d, the etching method may be a dry etching using an angle-etching and a chemical dry etching to form lower edges of the trench in a rounded shape 405. In detail, the first insulating layer and the substrate are etched by a dry etching using an angle etching, the photoresist is removed, and a chemical dry etching using CF_{4/}O₂ or CHF_{3/}O₂ is performed. Therefore, uniformity of a layer to be deposited later can be increased.

Referring to FIG. 3e, a trench gate is formed by depositing and planarizing a second insulating layer 306 and a conductor 307. A second insulating layer is formed as a gate insulating layer on the substrate in which the trench is already formed. A conductor for the gate is formed on the second insulating layer. Next, the conductor and the second insulating layer are planarized by CMP. The first insulating layer is used as an etch-stop layer. When the first insulating layer is exposed, the CMP process is stopped. The conductor is preferably made of one selected from the group consisting of polysilicon, tungsten alloy, titanium alloy, and tantalum alloy. The second insulating layer is preferably made of one selected from the group consisting of tantalum oxides, titanium oxides, and hafnium oxides.

Referring to FIG. 3f, after spacers 308 are formed by etching the first insulating layer, a source/drain region 312 is formed by an ion implantation using the gate and the spacers as a mask. The first insulating layer except for a portion of the layer positioned on sidewalls of the second insulating layer as the gate insulating layer is removed by an anisotropic etching and, consequently, spacers are formed. A source/drain region is formed by an ion implantation process of impurities of low concentration using the gate and the spacers as a mask. The ion implantation energy to form the source/drain region preferably has a value between 10 keV and 100 keV.

If damage to the gate due to the etching for formation of the spacers is serious, the spacers can be formed by removing the whole of the first insulating layer by etching, then forming and etching an insulating layer for spacers. The insulating layer for spacers is preferably a nitride layer or an oxide layer.

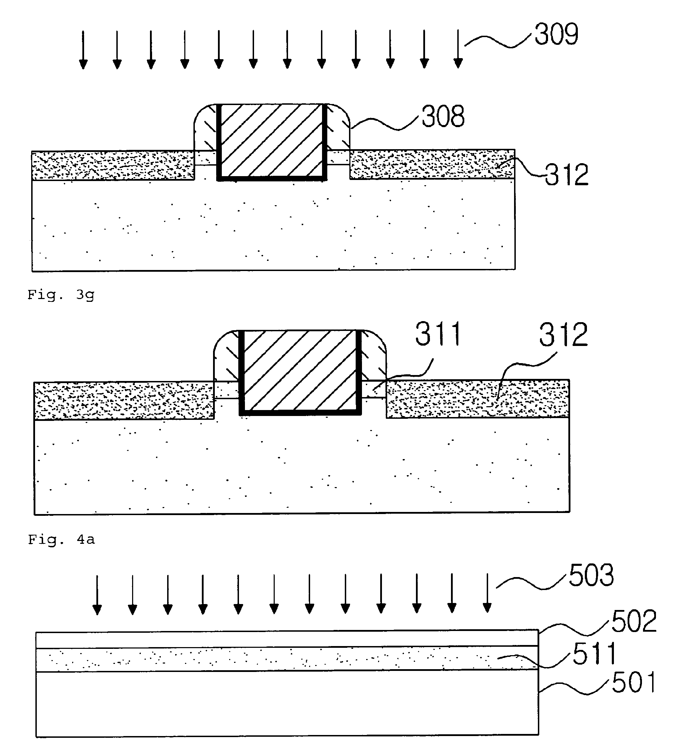

Referring to FIG. 3g, the LDD region 311 and the source/drain region 312 are stabilized by a thermal process. The LDD region 311 is formed above the gate. However, the LDD region and the source/drain region are stabilized and diffused by the thermal process, so that channel length can be controlled.

FIGS. 4a through 4g illustrate still another embodiment of the present invention.

First, referring to FIG. 4a, a first insulating layer 502 is deposited on a silicon substrate 501 and an LDD region 511 is formed using an ion implantation 503. The first insulating layer works as a buffer layer for the ion implantation and is preferably a nitride layer deposited with a thickness between 500 Å and 1500 Å. The ion implantation energy to form the LDD region preferably has a value between 5 keV and 60 keV.

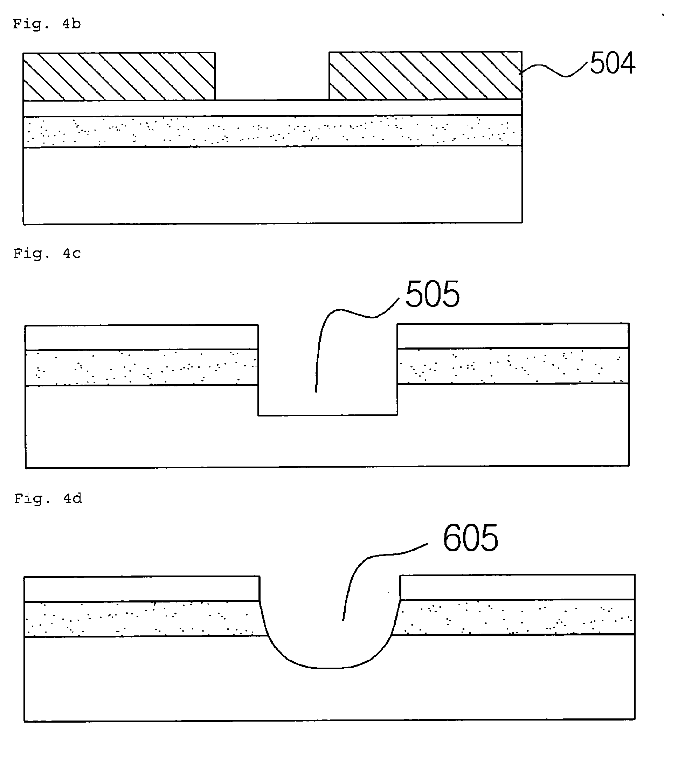

Referring to FIG. 4b, a first photoresist 504 is deposited on the first insulating layer and patterned. A first photoresist is formed on the first insulating layer. Then, an area for a gate is patterned in the first photoresist with development and lithography processes.

Referring to FIG. 4c, a trench 505 is formed by etching the substrate. A trench for a gate is formed by etching the first insulating layer and the substrate using the first photoresist patterned as a mask. Then, the first photoresist is removed. The trench length preferably has a value between 100 Å and 1000 Å. The etching method may be a dry etching with an etching angle between 5° to 30°.

As illustrated in FIG. 4d, the etching method may be an etchback using CDE (Chemical Dry Etching) to form lower edges of the trench in a rounded shape 605. Therefore, uniformity of a layer to be deposited later can be increased.

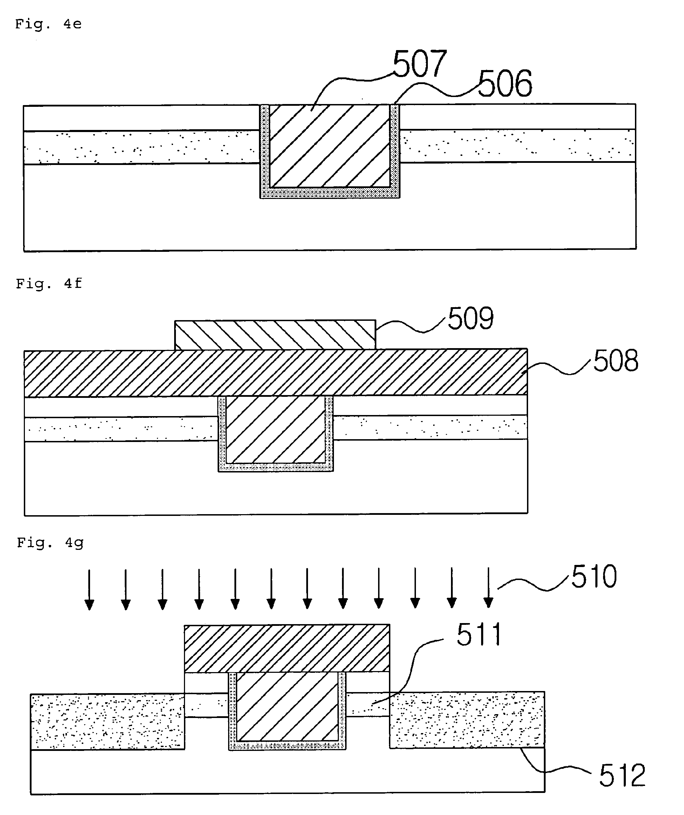

Referring to FIG. 4e, a second insulating layer 506 and a first conductor 507 are deposited and planarized. An oxide layer for a second insulating layer is formed on the substrate in which the trench is already formed. A conductor for a gate is formed on the second insulating layer. Next, the conductor and the second insulating layer are planarized by a CMP (Chemical Mechanical Polishing). The first insulating layer is used as an etch-stop layer. When the first insulating layer is exposed, the CMP process is stopped. The first conductor is preferably made of polysilicon. The second insulating layer may be formed of silicon dioxide using a conventional thermal oxide method or chemical vapor deposition and a multi-layer of oxide material can be also used. The thickness of the second insulating layer preferably has a value between 15 Å and 80 Å.

Referring to FIG. 4f, after a second conductor 508 and a second photoresist 509 are sequentially formed, the second photoresist is patterned. A second conductor is deposited on the substrate for which the planarization process has been finished. A second photoresist is formed on the second conductor. The second conductor is preferably made of one selected from the group consisting of tungsten alloys, titanium alloys, and tantalum alloys. The second photoresist is patterned by a photo etching process.

Referring to FIG. 4g, the second conductor and the first insulating layer are etched using the second photoresist patterned as a mask. The second photoresist is removed and a source/drain region 512 is formed by an ion implantation process 510. The ion implantation energy to form the source/drain region preferably has a value between 30 keV and 80 keV. An oxide layer may be formed as a buffer layer for the ion implantation to protect the substrate, and removed after the ion implantation. The first insulating layer etched functions as a spacer. A metallic material is used for the second conductor on the polysilicon, the first conductor, so a resistance with contacts formed by a later process can be reduced.

The LDD region and the source/drain region are stabilized and diffused by a later thermal process, so that channel length can be controlled.

Thus, a method for fabricating a transistor of a semiconductor device according to the present invention can lower source/drain resistance and gate resistance without any additional process by forming a trench type gate and can efficiently control a short channel effect.

The foregoing embodiments are merely exemplary and are not to be construed as limiting the present invention. The present teachings can be readily applied to other types of apparatuses. The description of the present invention is intended to be illustrative, and not to limit the scope of the claims. Many alternatives, modifications, and variations will be apparent to those skilled in the art.

The features disclosed in the foregoing description, in the claims and/or in the accompanying drawings may, both separately and in any combination thereof, be material for realising the invention in diverse forms thereof.

## Claims

1. A method for fabricating a transistor of a semiconductor device comprising the steps of:
forming an LDD region using an ion implantation after depositing a first insulating layer on a semiconductor substrate;
forming a trench in the substrate after patterning the first insulating layer;
forming a trench gate by depositing and planarizing a second insulating layer and a conductor on the substrate with the trench;
forming a source/drain region by forming a photoresist pattern on the substrate with the trench gate and performing an ion implantation using the photoresist pattern as a mask; and
removing the photoresist pattern and the first insulating layer.

2. The method as defined by claim 1, further comprising the step of performing a thermal process after the step of removing the first insulating layer.

3. The method as defined by claim 1, wherein the first insulating layer works as a buffer layer for the substrate during the ion implantation to form the LDD and the source/drain region.

4. The method as defined by claim 1, wherein the first insulating layer is made of one selected from the group consisting of nitrides, tantalum oxides, titanium oxides, and hafnium oxides.

5. The method as defined by claim 1, wherein the conductor is made of one selected from the group consisting of tungsten alloys, titanium alloys, and tantalum alloys.

6. The method as defined by claim 1, wherein energy for the ion implantation to form the LDD region has a value between 30 keV and 80 keV.

7. The method as defined by claim 1, wherein energy for the ion implantation to form the source/drain region has a value between 5 keV and 60 keV.

8. The method as defined by claim 1, wherein the trench is formed by a dry etching with an etching angle between 5° and 30°.

9. The method as defined by claim 1, wherein the etching method for forming the trench is an etchback using chemical dry etching.

10. The method as defined by claim 9, wherein lower edges of the trench are formed in a rounded shape by the chemical dry etching.

11. The method as defined by claim 1, wherein the planarization is a CMP process using the first insulating layer as an etch-stop layer.

12. The method as defined by claim 1, wherein the first insulating layer is removed by a wet etching using phosphoric acid solution.

13. A method for fabricating a transistor of a semiconductor device comprising the steps of:
forming an LDD region using an ion implantation on a substrate;
forming a first insulating layer on the substrate;
forming a trench in the substrate after patterning the first insulating layer;
forming a trench gate by depositing and planarizing a second insulating layer and a conductor on the substrate with the trench;
anisotropically etching the first insulating layer to form spacers; and
forming a source/drain region by performing an ion implantation on the substrate using the spacers and the gate as a mask.

14. The method as defined by claim 13, further comprising the step of performing a thermal process after the step of forming the source/drain region.

15. The method as defined by claim 13, wherein the first insulating layer is an oxide layer or a nitride layer.

16. The method as defined by claim 13, wherein the conductor is made of one selected from the group consisting of polysilicon, tungsten alloys, titanium alloys, and tantalum alloys.

17. The method as defined by claim 13, wherein energy for the ion implantation to form the LDD region has a value between 10 keV and 80 keV.

18. The method as defined by claim 13, wherein energy for the ion implantation to form the source/drain region has a value between 10 keV and 100 keV.

19. The method as defined by claim 13, wherein the trench is formed by a dry etching.

20. The method as defined by claim 13, wherein the trench is formed by a dry etching using an angle etching and chemical dry etching.

21. The method as defined by claim 20, wherein lower edges of the trench are formed in a rounded shape by the chemical dry etching.

22. The method as defined by claim 20, wherein the chemical dry etching uses CF_{4/}O₂ or CHF₃/O₂.

23. The method as defined by claim 13, wherein the planarization is a CMP process using the first insulating layer as an etch-stop layer.

24. A method for fabricating a transistor of a semiconductor device comprising the steps of:
forming an LDD region using an ion implantation after depositing a first insulating layer on a semiconductor substrate;
forming a trench in the substrate after patterning the first insulating layer;
forming a trench gate by depositing and planarizing a second insulating layer and a first conductor on the substrate with the trench;
depositing a second conductor on the substrate with the trench gate and patterning the second conductor and the first insulating layer; and
forming a source/drain region by performing an ion implantation using the second conductor pattern as a mask.

25. The method as defined by claim 24, wherein the first insulating layer works as a buffer layer for the substrate during the ion implantation to form the LDD region.

26. The method as defined by claim 24, wherein the first insulating layer is a nitride layer.

27. The method as defined by claim 24, wherein the first conductor is made of polysilicon and the second conductor is made of one selected from the group consisting of tungsten alloys, titanium alloys, and tantalum alloys.

28. The method as defined by claim 24, wherein energy for the ion implantation to form the LDD region has a value between 5 keV and 60 keV.

29. The method as defined by claim 24, wherein energy for the ion implantation to form the source/drain region has a value between 30 keV and 80 keV.

30. The method as defined by claim 24, wherein the planarization process is a CMP process.

31. The method as defined by claim 30, wherein the CMP process uses the first insulating layer as an etch-stop layer.
